(19) Europäisches Patentamt
European Patent Office
Office européen des brevets

(11) **EP 4 672 603 A1**

(12) **EUROPEAN PATENT APPLICATION**

(43) Date of publication:
**31.12.2025 Bulletin 2026/01**

(21) Application number: **24185220.1**

(22) Date of filing: **28.06.2024**

(51) International Patent Classification (IPC):
**H03K 5/135** (2006.01)    **H03K 5/131** (2014.01)
**H03K 3/03** (2006.01)    **H03K 5/00** (2006.01)

(52) Cooperative Patent Classification (CPC):
**H03K 5/135; H03K 5/131;** H03K 3/0315;
H03K 2005/00032; H03K 2005/00065;
H03K 2005/00104

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **The Swatch Group Research and
Development Ltd
2074 Marin (CH)**

(72) Inventors:
• **AREND, Jean-Luc
2035 Corcelles (CH)**
• **CASAGRANDE, Arnaud
2014 Bôle (CH)**

(74) Representative: **ICB SA
Faubourg de l'Hôpital, 3
2001 Neuchâtel (CH)**

(54) **ELECTRONIC CIRCUIT AND METHOD FOR ADJUSTING A TRANSITION TIME OF BUFFERS OF A BUFFER CHAIN**

(57)    In one aspect the present invention relates to an electronic circuit (100) comprising:
- a chain (12) of buffers (40, 40', 40"), wherein each buffer (40) comprises a buffer input (45), a buffer output (46), a buffer current source (44) and a buffer capacitor (43) and wherein a transition time of each buffer (40, 40', 40") is controllable by the buffer current source (44, 44', 44"),

- an oscillator (70, 71, 72) configured to generate an oscillating reference signal, and
- a control circuit (80) coupled to the oscillator (70, 71, 72) and coupled to the buffer current sources (44, 44', 44") of the buffers (40, 40', 40") and operable to adjust the transition time of each buffer (40, 40', 40") on the basis of the oscillating reference signal.

Fig. 3

EP 4 672 603 A1

**Description**

<u>Field of the invention</u>

In one aspect, the present invention relates to the field of electronic circuits, and in particular to electronic circuits configured to adjust a transition time of buffers of a chain of buffers. In some aspects, the chain of buffers may be operable to generate a ramped current signal, e.g., for a receiver circuit, such as a regenerative receiver.

<u>Background</u>

For generating a ramped current or bias signal, which may be useful in the operation of a regenerative receiver, e.g., a regenerated or super-regenerative receiver, it is usually necessary to generate a voltage ramp and convert this ramp signal to a current via a voltage-to-current converter. However, such approaches are limited by the additional noise of the converter and the reduced linearity of the converter, particularly when the supply voltage is low. Moreover, and in applications with regenerative receivers, and in particular with so-called super-regenerative receivers, such a current ramp generation must be supplemented by a system for measuring the start-up time and converting the start-up time to the digital domain, e.g. by way of a time-to-digital converter.

A ramped current signal may be obtainable on the basis of a chain of buffers, for each buffer associated with or provided with a discrete current source. The switching of the individual buffers and hence switching of the current sources to contribute to a main output current the time profile of a signal finally generated is directly dependent on the control chain trigger time and may be therefore not a priori stable.

Moreover, in integrated technology and in some analog-to-digital converters, a self-controlled trigger signal can be used to perform various operations required, e.g. dichotomy or intermediate comparisons, for a converter to operate in the absence of a clock signal. Such operations are generally sequenced by the digital signal transition in an uncontrolled manner and are directly dependent on a process, a system voltage and temperature conditions (PVT conditions). Consequently, the conversion time is directly dependent on these PVT conditions. Also, a parasitic characteristic associated with the conversion, such as a parasitic radiation or current profile consumed on the power supply, are not controlled in this case and are directly dependent on the PVT conditions.

In view of the above, it is hence desirable to precisely control a trigger timing of a trigger chain, e.g. of a self-controlled asynchronous chain that might be used in the creation or sampling of an analog signal in an integrated structure, for example of CMOS type.

<u>Summary of the invention</u>

In one aspect, the present invention relates to an electronic circuit. The electronic circuit comprises a chain of buffers or cascade of buffers. Each buffer comprises a buffer input, a buffer output, a buffer current source and a buffer capacitor. A transition time of each buffer is controllable by the buffer current source. The electronic circuit further comprises an oscillator. The oscillator is configured to generate an oscillating reference signal. The electronic circuit further comprises a control circuit or controller, which is coupled to the oscillator and which is also coupled to the buffer current sources of the chain of buffers.

The control circuit is operable to adjust the transition time of each buffer on the basis of the oscillating reference signal. In this way, the transition time of each buffer can be calibrated or regulated and the total transition time of the entire chain of buffers can be controlled.

In some examples, the chain of buffers is configured to provide a ramped current or ramped current signal, wherein the ramp or ramp time directly depends on the sum of the transition times of each buffer. Now, and with the control circuit, the transition time of each buffer can be controlled, adjusted or calibrated on the basis of the oscillating reference signal as provided by the oscillator. It is hence possible to provide a control and calibration of the ramp time for the ramped current signal.

According to a further example, the electronic circuit comprises a digital to analog converter. The digital to analog converter comprises an analog output connected to each buffer current source. By way of a digital to analog converter, the buffer current sources of the chain of buffers can be controlled in a digital way, i.e., by way of a digital signal.

Moreover, the control circuit may be equipped or may comprise a dichotomy engine, which allows for a rather precise and well-defined adjustment, regulation or calibration of each buffer current source of the chain of buffers.

In a further example, the control circuit comprises a dichotomy engine, which is configured to generate a digital input signal for the digital to analog converter. The dichotomy engine is configured to populate a bit chain of predefined size with digital values in a sequential and iterative manner. In a first step, and depending on a measurement of a feedback from the chain of buffers, the dichotomy engine may be configured to set a first bit value. In a subsequent step and with the first bit value fed back into the chain of buffers and thus having an influence on the transition time, the dichotomy engine is configured to populate a subsequent or second bit value again in accordance to a measured feedback from the chain of buffers; and so on.

In this way, the control circuit with the dichotomy engine may provide a stepwise and iterative population of a number of bits representing an analog value for controlling each buffer current source. In some examples, the dichotomy engine is configured to define or to derive one of an 8 bit control signal, a 16 bit control signal, a 32-bit control signal or a 64-bit control signal, which is provided to the digital-to-analog converter for controlling each one of the buffer current sources of the chain or cascade of buffers of the electronic circuit.

According to a further example, the oscillator comprises a clock and the clock is configured to generate a clock signal. The clock may be implemented as a high frequency divided clock. The clock may provide a reference for measuring a temporal behavior of the chain of buffers and/or for measuring the transition time of each or of all buffers of the chain of buffers of the electronic circuit. Moreover, the clock may also be coupled to the control circuit and may be operable to drive or to operate the control circuit, e.g., the dichotomy engine.

According to a further example, the electronic circuit further comprises a counter, which is connected to the clock and which is operable to count a sequence of clock signals provided by the clock. By counting a discrete number of clock signals and by setting the number of clock signals in relation to the behavior of the chain of buffers, a total transition time of the entire chain of buffers can be directly measured and can be further compared with a predefined reference value. In this way, a calibration of the transition time of each buffer of the chain of buffers can be provided on the basis or as a function of a high-frequency local oscillator.

Here, the transition time of the complete chain of buffers can be measured and compared with a precise time reference, generated on the basis of the clock, e.g. implemented as a local high-frequency divided clock. The current control parameter for the individual buffer current sources can be derived by the dichotomy engine to adjust the transition time of each buffer to a desired or predefined value.

According to a further example, the electronic circuit comprises a flip-flop, e.g. a D flip-flop with a first input connected to an end of the chain of the buffers and with a further input connected to the counter.

Here, an output of the flip-flop is connected to the control circuit. In some examples the output of the flip-flop may be directly connected to an input of the dichotomy engine.

By way of the flip-flop, a counter value of the counter, which coincides with a switching or transition of the last buffer of the chain of buffers, can be supplied to the control circuit and/or to the dichotomy engine, which may then derive a digital value for controlling and/or for providing a control signal for each buffer current source of the chain of buffers.

According to a further example an end of the chain of buffers is connected to a start of the chain of buffers via an inverter. In this way, the entire chain of buffers can be put into an oscillation mode, namely by placing an inversion on the path of the pain of buffers and by closing this chain or path on itself. Consequently, and as the chain of buffers will be driven by an input signal the entire chain of buffers will start to oscillate.

Then, the oscillation frequency may be measured and may be used to control the individual buffer current sources. Here, there may be provided a comparison with a precise value, e.g., with a control parameter or reference frequency as described above.

The closed loop of the chain of buffers with the inverter between the last buffer and the first buffer of the chain of buffers has the benefit that a transition time and a respective switching behavior of the entire chain can be controlled on the basis of a low-frequency signal and hence by use and by a comparison with a low-frequency local oscillator. Here, the frequency of the switching of the entire chain of buffers may be compared with a reference frequency, which reference frequency may be directly derived from the clock or from a low-frequency local oscillator.

According to a further example, the electronic circuit also comprises a frequency comparator comprising a first input connected to the clock and comprising a second input connected to an end of the chain of buffers. The frequency comparator further comprises an output connected to the control circuit, e.g., connected to the dichotomy engine of the control circuit. Here, the frequency comparator may be configured to compare the frequency of the oscillator of the closed or looped chain of buffers with a reference frequency, which reference frequency may be provided by a low-frequency local oscillator.

According to a further example, the oscillator of the electronic circuit comprises a ring oscillator and the control circuit comprises a tunable resistor arranged parallel to the ring oscillator. Such a ring oscillator arrangement may provide a specific RC oscillator, which is polarization independent of the above-mentioned PVT conditions. Here and with a RC oscillator on the basis of a ring oscillator, it is possible to use an internal frequency of the entire system directly for generating a current that allows and provides a constant delay or transition time for each buffer even independent of the environmental conditions or PVT parameters. Generally, such a ring oscillators or ring oscillator arrangement is known and described e.g. in EP 4 207 598 A1, the entirety of which being incorporated herein by reference.

The electronic circuit equipped with the ring oscillator comprises a first branch provided with the ring oscillator and further comprises a second branch provided with the tunable resistor. Both branches are connected to ground through a current mirror which gate is driven by an OTA (Operationnal Trans-conductance Amplifier).

The OTA is driven by both ring oscillator supply voltage (91) and resistor voltage (93), which force those two voltages to be equal. This arrangement provides both equal currents in the two branches (because branches are connected through a current mirror), and equal voltage (because of the OTA feedback). This particular arrangement allows to define a ring oscillator frequency which is only proportional to 1/(R * C) and independent of the PVT conditions.

Accordingly, there will be provided a varying current versus PVT variations within the current mirror (providing fixed frequency versus PVT variations within the ring oscillator arrangement). This current is then mirrored further (40, 40', 40") to provide a fixed transition time for each buffer of the so biased trigger chain (versus PVT variations).

According to a further example, the present electronic circuit is configured to control or to calibrate a regenerative receiver or to calibrate another electronic circuit, which is configured to generate a ramped current signal for such a regenerative receiver or receiver circuit. Here, the other electronic circuit may comprise a first current cell comprising a first current source, a trigger input to activate the first current source and a trigger output. The other electronic circuit may further comprise a second current cell comprising a second current source, a trigger input to activate the second current source and the trigger output. The trigger output of the first current cell is connected to the trigger input of the second current cell. The other electronic circuit or regenerative receiver further comprises a current supply connected to a supply input of the receiver circuit and connectable with any of the first current source and the second current sources.

The electronic circuit as described and claimed herein is particularly configured to adjust the transition time or delay of each of the first and second and of any optional further current cells of the other electronic circuit. Here, each one of the first current cell and the second current cell comprises a buffer to transfer an input signal at the trigger input to the trigger output of the respective current cell after lapse of a predefined transition time. With the electronic circuit as described above the transition time of each buffer and hence the transition time of each current cell of the other electronic circuit can be suitably calibrated or adjusted thus allowing to control the timing or the timescale of a ramped current signal to be generated by the other electronic circuit and used by the regenerative receiver.

According to another aspect, the present invention also relates to a method of adjusting or controlling a transition time of buffers of a chain of buffers. The method comprises the steps of using an electronic circuit as described above, generating an alternating reference signal and adjusting a transition time of each buffer on the basis of the constant versus PVT oscillating reference signal. Since the method of adjusting or controlling the transition time of buffers of a chain of buffers as described herein has to be or can be conducted with an electronic circuit as described above, all features, effects and benefits as described above in connection with the electronic circuit equally apply to the method of adjusting or controlling the transition time of buffers of the chain of buffers; and vice versa.

Brief description of the drawings

In the following numerous examples of the invention will be described in greater detail by making reference to the drawings, in which:

- Fig. 1 shows a block diagram of an example of the regenerative receiver,

- Fig. 2 shows an example of a current cell of the electronic circuit of the receiver,

- Fig. 3 shows an example of a control circuit for controlling the transition time of the buffers of a buffer chain,

- Fig. 4 shows another example of a control circuit for controlling the transition time of the buffers of a buffer chain, and

- Fig. 5 shows a further example of a control circuit for controlling the transition time of the buffers of a buffer chain.

Detailed description of the invention

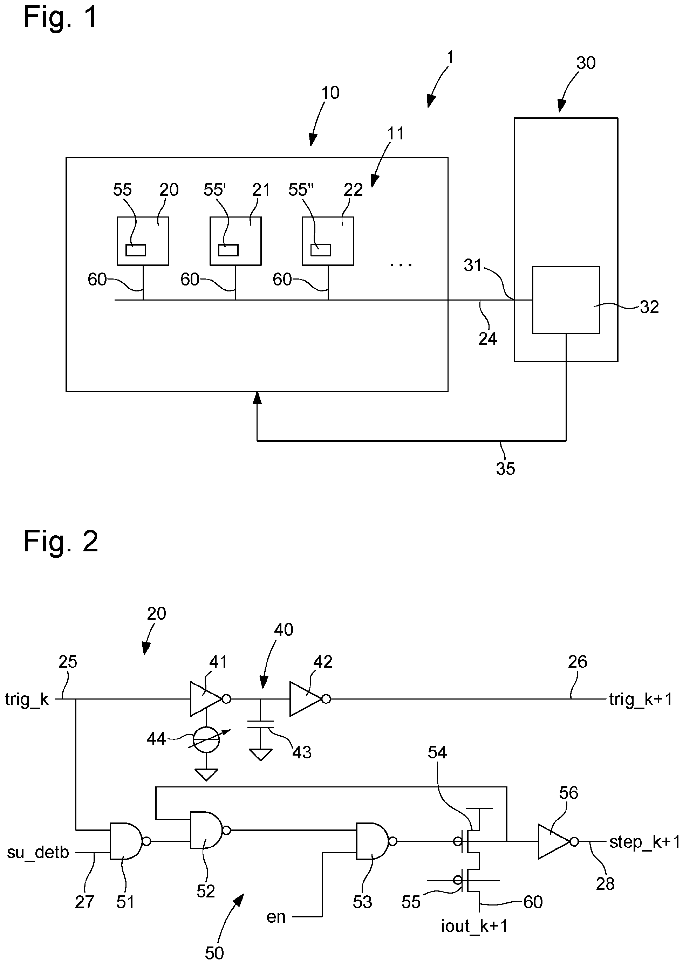

In Fig.1, there is shown a regenerative receiver 1. The regenerative receiver 1 comprises a receiver circuit 30, e.g., in form of a super-regenerative receiver. The regenerative receiver 1 comprises a receiver circuit 30 and an electronic circuit 10. The electronic circuit 10 is configured to supply a ramped current signal or ramped current to the receiver circuit 30 in order to start-up operation of the receiver circuit 30. The receiver circuit 30 inter alia comprises an oscillation detector 32, which detects the regenerative oscillator signal. The supply input 31 is connected with a current supply 24 of the electronic circuit 10. The oscillation detector 32 may comprise an analog circuit which is operable to detect the oscillation start-up which depends on the input current provided at the current supply 24 and at the supply input 31.

If the current at the supply input 31 should be equal to or larger than the current requested to start the oscillation of the regenerative oscillator, the oscillation detector 32 is configured to generate and to provide a feedback signal via a feedback line 35 to the electronic circuit 10. When receiving such a feedback signal via the feedback line 35 the electronic circuit 10 may freeze and may stop generation or evolution of an increasing current at the current supply 24.

The electronic circuit 10 comprises numerous current cells 20, 21, 22. Each current cell 20, 21, 22 comprises a similar or identical structure, which is illustrated in Fig. 2. Each current cell 20, 21, 22 comprises a current source 55, 55', 55". Moreover, each current cell 20, 21, 22 is connected to the current supply 24 via a current output 60. The individual current cells 20, 21, 22 are arranged and connected in parallel with regards to the current supply 24. In this way, each current cell 20, 21, 22 may provide a current cell specific current, which add to a main current at the current supply 24.

As shown in Fig. 2, each current cell 20 comprises a current source 55, a trigger input 25 and a trigger output 26. The individual cells 20, 21, 22 of the electronic circuit 10 are arranged to form a cascade arrangement 11 or chain of the current cells 20, 21, 22. The chain is formed by connecting the trigger output 26 of the first current cell 20 to the trigger input 25 of the second current cell 21.

A respective trigger output 26 of the second current cell 21 is connected to a trigger input 25 of the third current cell 22, and so on. In the illustration of Fig. 1, there are shown only three current cells 20, 21, 22 for reasons of simplicity. The number of individual current cells 20, 21, 22 can be arbitrarily expanded to a number of more than 20, more than 50, more than 100, more than 200, more than 500 or more than 1000.

The trigger input 25 is connected to the trigger output 26 via a buffer 40. The buffer 40 comprises a first inverter 41 in series with a second inverter 42. The first inverter 41 is further connected with a buffer current source 44. The output of the first inverter 41 and the input of the second inverter 42 are mutually connected. The output of the second inverter 42 is connected to the trigger output 26.

A node located between the output of the first inverter 41 and the input of the second inverter 42 is connected with a buffer capacitor 43, which is connected to ground with an opposite end.

A trigger signal trig_k present at the trigger input 25 can propagate through the buffer 40 with a predefined delay. The rising flank of the trigger signal trig_k leads to the generation of a logical 0 at the output of the first inverter 41 by way of which the buffer capacitor 43 may discharge via the buffer current source 44. By way of this discharging process the voltage at the input of the second inverter 42 decreases at a particular rate and when a switching voltage for the second inverter 42 has been reached the output of the second inverter 42 changes its state from low to high.

Accordingly, there will be generated a trigger signal trig_k+1 at the trigger output 26 after lapse of a predefined transition time of the buffer 40. The transition time defines a kind of a discrete time interval at which the individual current(s) produced and provided by the individual current cells 20, 21, 22 can sum up to the total current provided at the current supply 24. The duration of the transition time may be controlled by tuning the buffer current source 44.

The individual current cells 20, 21, 22 each comprise a logic unit 50. The logic unit 50 operates on a rising edge of the trigger signal trig_k. Hence, the trigger input 25 can be processed by the logic unit 50 in such a way to switch on and/or to connect the first current source 55 to the current output 60, the latter of which being connected to the current supply 24 and provides an output current iout_k+1.

As particularly illustrated in Fig. 2, the current source 55 may be programmable and may provide a current of a predefined amplitude or size. In the embodiment as shown in Fig. 2, the current source 55 comprises a PMOS transistor that is in series with another PMOS transistor 54. The further PMOS transistor 54 acts as a switch for switching the current source 55 and hence for activating the current source 55 to deliver a current to the current output 60.

The logic unit 50 comprises a first gate 51, a second gate 52 and a third gate 53. The logic unit 50 further comprises an inverter 56. Moreover, the logic unit 50 comprises an interrupt input 27 and a current cell activation indicator output 28. The interrupt input 27 of each of the current cells 20, 21, 22 can be connected to the feedback line 35. The feedback line 35 may provide a su_detb signal to the interrupt input 27. The gates 51, 52 and 53 are all implemented as NAND gates. This has the benefit to implement such a logic structure with a comparatively low number of transistors. It is hence particularly suitable for miniaturization.

As illustrated in Fig. 2, the trigger input 25 is connected to a first input of the first gate 51 and the interrupt input 27 is connected to a second input of the gate 51. An output of the gate 51 is connected to an input of the second gate 52. The other input of the second gate 52 is connected to the gate of the switching transistor 54. The output of the second gate 52 is connected to an input of the third gate 53. Another input of the third gate 53 is connected to an enabling input en, which may be controllable by the receiver circuit 30. The output of the third gate 53 is connected to the gate of the switching transistor 54. An input of the inverter 56 is also connected to the gate of the switching transistor 54 and the output of the inverter 56 is connected to or forms the current cell activation indicator output 28 at which a step_k+1 signal and hence a flag signal can be detected.

In an initial configuration and, when the electronic circuit 10 is in an idle mode before start-up, the trigger input 25 will not yet be provided with a trigger signal trig_k. The su_detb signal is initially at a logical 1. Accordingly, and in the initial state of the current cell 20 the output of the first gate 51 is a logical 1. The gate of the switching transistor 54 is at a logical 1 as well such that the output of the second gate 52 is at a logical 0. Since the electronic circuit 10 is in a working mode the enable signal en is at logical 1.

Accordingly, the output of the third gate 53 is at a logical 1 as well. Since the interrupt output 28 is connected to the gate of the switching transistor 54 via the inverter 56, there will be no signal present at the current cell activation indicator output 28.

When the electronic circuit 10 is now activated to generate a ramped current signal there will be provided a trigger signal trig_k at the trigger input 25. Toggling of the trigger input 25 from logical 0 to logical 1 will lead to the generation of a logical 0 at the output of the first gate 51. This logical 0 then leads to the generation of a logical 1 at the output of the second gate 52 and will induce generation of a logical 0 at the output of the third gate 53. Turning down the gate of the PMOS switch 54 from logical 1 to logical 0 will activate the switch 54 such that the current source 55 will be activated and will provide a current source specific current to the current output 60. Furthermore, the logical 0 at the gate of the switching transistor 54 will be transferred into a logical 1 via the inverter 56 at the current cell activation indicator output 28.

Hence, at the current cell activation indicator output 28 there will arise a flag signal step_k+1 indicating that the current source 55 has been switched on or has been activated.

As already indicated above providing the trigger signal trig_k to the trigger input 25 will generate a respective trigger signal trig_k+1 at the trigger output 26, wherein the trigger signal trig_k+1 at the output will arise or will be generated after lapse of a predefined transition time interval. Thereafter, a proceeding current source 21 will undergo the same transition and will add a respective supplemental current to the current supply 24.

The cascade of numerous current cells 20, 21, 22 will continue and each current cell 20, 21, 22 will add current cell specific current to the current supply 24 until the oscillation detector 32 detects that the total current as provided by the current supply 24 reaches or exceeds the critical current requested to start the regenerative oscillator. When reaching such target, the oscillation detector32 generates a feedback signal and transfers this feedback signal as a logical 0 via the feedback line 35 to all interrupt inputs 27 of all current cells 20, 21, 22.

With the trigger signal 25 at a logical 1 and with a switching of the su_detb signal from a logical 1 to a logical 0 the trigger input 25 will be effectively decoupled from the logic unit 50 and hence from the current source 55. Insofar and by setting the interrupt inputs 27 of one of the current cells 20, 21, 22 to a logical 0 there can be provided an effective decoupling of the trigger input 25 from the current source 55. Then, the output of the first gate 51 will always be at a logical 1 irrespective of the value or signal provided at the trigger input 25.

Insofar, setting the su_detb signal at each interrupt input 27 of the current cell 20, 21, 22 to a logical 0 effectively freezes the current switching state of all current cells 20, 21, 22 even though the trigger signal may further propagate through the number of individual current cells 20, 21, 22. It may have no longer an effect on the switching behavior of a respective switching transistor 54.

At the same time and with the freezing of each current cell 20, 21, 22 there can be provided a stable and continuous current at the current supply 24. At the same time the current cell activation indicator output 28 of all current cells 20, 21, 22 is immediately indicative of the activation of the respective current source 55 of each activated current cell 20, 21, 22. This way, there is immediately provided a digital signal being indicative of a number of current cells 20, 21, 22 that have been activated until the reference current has been reached by the ramped current signal as provided at the current supply 24.

With a given transition time of each buffer 40 of the individual current cells 20, 21, 22, there can be derived a total ramp time in the digital domain that is required by the electronic circuit 10 to reach a predefined amplitude of an output current at the current supply 24.

The ramped current signal at the current supply 24 can be resetted by supplying a reset signal to the enabling input en. Then, and in response to such a reset signal the gate of the switching transistor 54 may be set to a logical 1 thus switching the switching transistor off.

It should be noted that the presently illustrated implementation of the basis of NAND gates and on the basis of PMOS transistors 54, 55 is only illustrative. The same or similar implementation can be easily obtained also on the basis of a positive logic and on the basis of NMOS switching devices.

Especially in the case of implementing a so-called super-regenerative receiver, the generation of a current ramp by the present regenerative receiver 1 is of particular benefit as it becomes possible to obtain a start-uptime directly in the digital domain by stopping the progression of the trigger chain, i.e., when the super-regenerative oscillator starts up, and consulting the thermometric number of current sources 55, 55', 55" that have been switched on, e.g., at the time the aforementioned oscillator starts up.

A simple thermometric to binary conversion can then be used to deduce the equivalent start-up time. The present type of thermometric generator is particularly well-suited to operation at very low voltages and has an ideal characteristic for "shrink" to smaller technologies. In the case of current generation, because the number of analog components is extremely limited, the noise performance of the system is excellent.

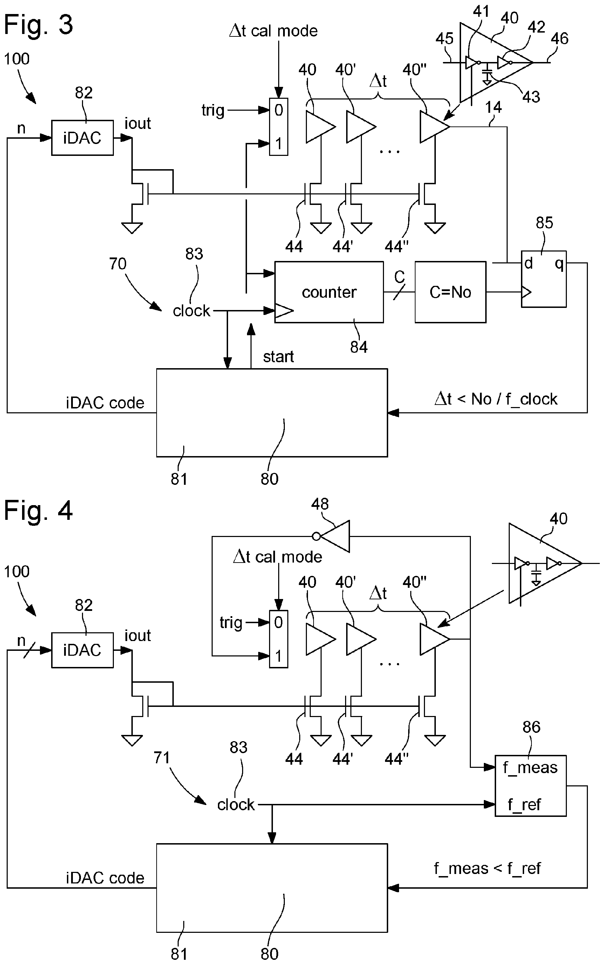

In the example of Fig. 3, there is illustrated a first example of the electronic circuit for adjusting or controlling the transition time of each of the buffers 40, 40', 40" of individual current cells 20, 21, 22 as described above in connection with any of Figs. 1 and 2. As described above, each current cell 20, 21, 22 comprises a buffer 40, 40', 40". Each buffer 40 comprises a buffer capacitor 43; a first and a second inverter 41, 42 as well as a buffer current source 44, which buffer current sources 44, 44', 44" are illustrated separately in Figs. 3 and 4.

The electronic circuit 100 as described in Figs. 3 and 4 comprises a chain 12 of buffers 40, 40', 40", wherein each buffer 40, 40', 40" belongs to a current cell 20, 21, 22 as described above in connection with Figs. 1 and 2.

In the example of Fig. 3, there is further provided an oscillator 70 comprising a clock 83. The clock 83 is used to trigger the chain 12 of buffers 40, 40', 40". Here, the buffers are triggered with the clock frequency f_clock.

The electronic circuit 100 further comprises a control circuit 80, which in the example of Fig. 3 is implemented as a dichotomy engine 81. The electronic circuit 100 further comprises a counter 84, which is driven by the clock 83. The counter 84 is configured to provide a momentary counted number after a reset, which reset coincides with the start of an activation of the chain 12 of buffers 40, 40', 40".

There is further provided a flip-flop 85 with a first input connected to an end 14 of the buffer chain 12 and with a further input connected to the number counting output of the counter 84. Once the chain of buffers 12 has successively switched, e.g. from a low value to a high value, the respective counter value will be provided at an output of the flip-flop and can be used as an input signal for the control circuit 80 and hence for the dichotomy engine 81.

Based on the total number of the counts that have been counted during a complete switching of the entire chain 12 of buffers 40, 40', 40", the dichotomy engine 81 will generate a digital output signal, which is applied to a current digital-to-analog converter 82. The digital to analog converter 82 is then configured to generate a respective output current, and this output current is connected to the base of all buffer current sources 44, 44', 44". In this way, the transition time of the complete chain 12 is measured and compared with a precise time reference as provided by the high-frequency clock 83. The current control parameter of the chain 12 of buffers 40, 40', 40" can be thus optimized to adjust the transition time of each buffer 40, 40', 40" to a desired value.

In the further example as shown in Fig. 4, only some minor amendments have been implemented compared to the design of the circuit 100 of Fig. 3. Here, the end 14 of the buffer chain 12 is connected to the start 16 of the buffer chain 12 through an inverter 48. Hence, the chain 12 of buffers 40, 40', 40" is closed on itself and once the buffer chain 12 is triggered there will arise an oscillation of the entire chain 12 with a measurable oscillation frequency f_meas. This oscillation frequency f_meas can be then compared with a reference frequency f_ref in a frequency comparator 86, which is connected to the end 14 of the buffer chain 12 and which is further connected to the low-frequency local oscillator 71, equally serving as a kind of a clock 83.

Here, the oscillation frequency of the entire chain 12 of buffers 40, 40', 40" is compared with a precise reference frequency f_re, which is derived from the low frequency clock 83. Here a comparison between the measured frequency f_meas of the entire buffer chain 12 and the reference frequency f_ref will be provided as an input signal for the control circuit 80 and for the dichotomy engine 81, which may be implemented in the same or like manner as described above in connection with Fig. 3.

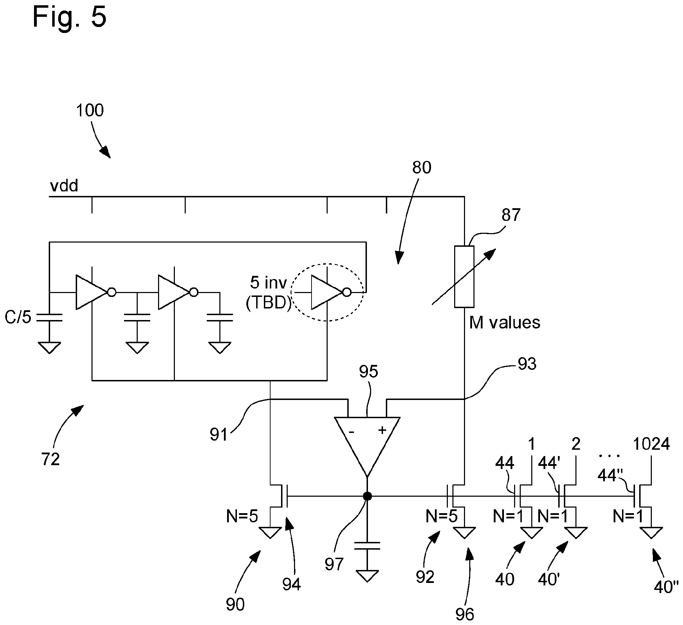

In Fig. 5 there is illustrated another example of an electronic circuit 100 configured to calibrate or to control and/or to adjust the transition time of each buffer 40, 40', 40". Here, the oscillator 72 comprises a ring oscillator located in a first branch 90. The electronic circuit 100 further comprises a second branch 92, which is provided with a tunable resistor 87. The first branch 90 further comprises a first current mirror arrangement 94 and the second branch 92 further comprises a second current mirror arrangement 96. As indicated in Fig. 5 each current mirror arrangement 94, 96 comprises a number of individual transistors, e.g., 5 transistors arranged in parallel.

The first branch 90 further comprises a first node and 91 located between the first current mirror arrangement 94 and the ring oscillator 72. The second branch 92 comprises a second node 93 which is located between the second current mirror arrangement 96 and the tunable resistor 87. The electronic circuit 100 further comprises an amplifier 95, e.g. implemented as an operational transconductance amplifier (OTA). A first input of the amplifier 95 is connected to the first node 91. A second input of the amplifier 92 is connected to the second node 93. The output of the amplifier 95, hence an amplifier output 97, is connected to the base of the first current mirror arrangement 94 and to the base of the second current mirror arrangement 96. The bases of the current mirror arrangements 94, 96 as well as the output of the amplifier 95 are connected to the base of the individual buffer current sources 44, 44' 44" of the respective buffers 40, 40', 40" and hence of the respective current cells 20, 21, 22 as described above.

The electronic circuit 100 according to Fig. 5 has the benefit to define a frequency of the ring oscillator 72

$$F_0 = \frac{1}{RC} \cdot \frac{V_R}{V_C}$$

that equals: , wherein $V_R$ is the voltage across the tunable resistor 87, wherein $V_c$ is the voltage across the ring oscillator, R being the resistance of the tunable resistor and C being the equivalent capacitance of the ring oscillator 72.

In the present example, this frequency is an internal value of the entire system but it is not necessarily used directly. It is a primary aim of the electronic circuit 100 and of the ring oscillator 72 of Fig. 5 to generate a current that allows a constant delay to be achieved independent of the PVT conditions or PVT parameters.

Nomenclature

1    regenerative receiver
10   electronic circuit
11   cascade arrangement
12   buffer chain
14   end
16   start
20   current cell
21   current cell
22   current cell

| | |
|---|---|
| 24 | current supply |
| 25 | trigger input |
| 26 | trigger output |
| 27 | interrupt input |
| 28 | current cell activation indicator output |
| 30 | receiver circuit |
| 31 | supply input |
| 32 | oscillation detector |
| 35 | feedback line |
| 40 | buffer |
| 41 | inverter |
| 42 | inverter |
| 43 | buffer capacitor |
| 44 | buffer current source |
| 45 | buffer input |
| 46 | buffer output |
| 48 | inverter |
| 50 | logic unit |
| 51 | gate |
| 52 | gate |
| 53 | gate |
| 54 | transistor |
| 55 | current source |
| 56 | inverter |
| 60 | current output |
| 70 | oscillator |
| 71 | oscillator |
| 72 | oscillator |
| 80 | control circuit |
| 81 | dichotomy engine |
| 82 | digital-to-analog converter |
| 83 | clock |
| 84 | counter |
| 85 | flip-flop |
| 86 | frequency comparator |
| 87 | tunable resistor |
| 90 | branch |
| 91 | node |
| 92 | branch |
| 93 | node |
| 94 | current mirror arrangement |
| 95 | amplifier |
| 96 | current mirror arrangement |
| 97 | amplifier output |

**Claims**

1. An electronic circuit (100) comprising:

   - a chain (12) of buffers (40, 40', 40"), wherein each buffer (40) comprises a buffer input (45), a buffer output (46), a buffer current source (44) and a buffer capacitor (43) and wherein a transition time of each buffer (40, 40', 40") is controllable by the buffer current source (44, 44', 44"),
   - an oscillator (70, 71, 72) configured to generate an oscillating reference signal, and
   - a control circuit (80) coupled to the oscillator (70, 71, 72) and coupled to the buffer current sources (44, 44', 44") of the buffers (40, 40', 40") and operable to adjust the transition time of each buffer (40, 40', 40") on the basis of the oscillating reference signal.

2. The electronic circuit (10) according to claim 1, further comprising a digital-to-analog converter (82) comprising an analog output connected to each buffer current source (44, 44', 44").

3. The electronic circuit (100) according to claim 2, wherein the control circuit (80) comprises a dichotomy engine (81) configured to generate a digital input signal for the digital-to-analog converter (82).

4. The electronic circuit (100) according to any one of the preceding claims, wherein the oscillator (70, 71) comprises a clock (83) to generate a clock signal.

5. The electronic circuit (100) according to claim 4, further comprising a counter (84) connected to the clock (83) and operable to count a sequence of clock signals provided by the clock (83).

6. The electronic circuit (100) according to claim 5 further comprising a flip-flop (85) with a first input connected to an end (14) of the chain (12) of buffers (40, 40', 40") and with a further input connected to the counter (84), wherein an output of the flip-flop (85) is connected to the control circuit (80).

7. The electronic circuit (100) according to any one of the preceding claims 1-4, wherein an end (14) of the chain (12) of buffers (40, 40', 40") is connected to a start (16) of the chain (12) of buffers (40, 40', 40") via an inverter (48).

8. The electronic circuit (100) according to claim 7 and claim 4, further comprising a frequency comparator (86) comprising a first input connected to the clock (83), comprising a second input connected to an end (14) of the chain (12) of buffers (40, 40', 40") and comprising an output connected to the control circuit (80).

9. The electronic circuit (100) according to claim 1, wherein the oscillator (72) comprises a ring oscillator and wherein the control circuit (80) comprises a tunable resistor (87) parallel to the ring oscillator.

10. The electronic circuit (100) according to claim 9 further comprising a first branch (90) provided with the ring oscillator and a second branch (92) provided with the tunable resistor (87), wherein the first branch (90) is connected to ground via a first current mirror arrangement (94) wherein the second branch (92) connected to ground via a second current mirror arrangement (96).

11. The electronic circuit (100) according to claim 10, wherein the first branch (92) comprises a first node (91) located between the ring oscillator (72) and the first current mirror arrangement (94) and wherein the second branch (92) comprise a second node (93) located between the tunable resistor (87) and the second current mirror arrangement (96).

12. The electronic circuit (100) according to claim 11, further comprising an amplifier (95) comprising a first input connected to the first node (91) and comprising a second input connected to the second node (93).

13. The electronic circuit (100) according to claim 12, wherein the amplifier (95) comprises an amplifier output (97) connected to a gate of the first current mirror arrangement (94) and connected to a gate of the second current mirror arrangement (96).

14. The electronic circuit (100) according to claim 13, wherein the amplifier output (97) is connected to the buffer current sources (44, 44', 44").

15. A method of adjusting or controlling a transition time of buffers (40, 40', 40") of a chain (12) of buffers (40, 40', 40"), the method comprising the steps of:

- using an electronic circuit (100) according to any one of the preceding claims,
- generating a constant versus PVT oscillating reference signal and
- adjusting a transition time of each buffer (40, 40', 40") on the basis of the oscillating reference signal.

# Fig. 1

# Fig. 2

## Fig. 3

## Fig. 4

Fig. 5

Europäisches
Patentamt
European
Patent Office
Office européen
des brevets

# EUROPEAN SEARCH REPORT

**Application Number**

EP 24 18 5220

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 531 974 B1 (CALLAHAN KENT R [US] ET AL) 11 March 2003 (2003-03-11) | 1-13,15 | INV. H03K5/135 |
| A | * column 1, line 65 - column 3, line 20; figures 3,4 * | 14 | H03K5/131 |
| | ----- | | ADD. |
| X | US 2013/342256 A1 (WADHWA SAMEER [US] ET AL) 26 December 2013 (2013-12-26) | 1-7, 9-13,15 | H03K3/03 H03K5/00 |
| A | * paragraphs [0021] - [0023]; figure 1 * <br> * paragraph [0024]; figure 2 * <br> * paragraphs [0035] - [0037]; figure 3B * <br> * paragraphs [0044] - [0046]; figure 4B * | 8,14 | |
| | ----- | | |
| X | US 2010/148838 A1 (VENKATARAMAN JAGANNATHAN [IN] ET AL) 17 June 2010 (2010-06-17) | 1,4-6, 9-13,15 | |
| A | * paragraphs [0020], [0021]; figures 3,4 * | 2,3,7,8, 14 | |
| | ----- | | |

|  |
|---|
| **TECHNICAL FIELDS SEARCHED (IPC)** |
| H03K |

The present search report has been drawn up for all claims

| Place of search | Date of completion of the search | Examiner |
|---|---|---|
| Munich | 11 December 2024 | Martínez Martínez, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 5220

This annex lists the patent family members relating to the patent documents cited in the above-mentioned European search report.
The members are as contained in the European Patent Office EDP file on
The European Patent Office is in no way liable for these particulars which are merely given for the purpose of information.

11-12-2024

| Patent document cited in search report | Publication date | Patent family member(s) | | Publication date |
|---|---|---|---|---|
| US 6531974 B1 | 11-03-2003 | NONE | | |
| US 2013342256 A1 | 26-12-2013 | US | 2013342256 A1 | 26-12-2013 |
| | | WO | 2013192327 A1 | 27-12-2013 |
| US 2010148838 A1 | 17-06-2010 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 4207598 A1